# EUROPEAN PATENT APPLICATION

(11) **EP 4 770 323 A1**
(43) Date of publication of application: **01.07.2026**
(21) Application number: 25197179.2
(22) Date of filing: 20.08.2025
(51) Int. Cl.: H10D 30/67, H10D 86/60

(54) **THIN FILM TRANSISTOR AND DISPLAY APPARATUS COMPRISING THE SAME**

(30) Priority: 31.12.2024 KR 20240201861
(71) Applicant: LG Display Co., Ltd., Seoul, 07336 (KR)
(72) Inventor: RYU, Jihee, 10845 Gyeonggi-do (KR); KO, Younghyun, 10845 Gyeonggi-do (KR); JANG, Jaeman, 10845 Gyeonggi-do (KR)
(74) Representative: Crew, Alexander Edward Ross

(57) **Abstract**

A thin transistor and a display apparatus comprising the same are disclosed. Disclosed is a thin film transistor comprising an active layer including a channel portion, a gate insulating layer on the active layer, and a gate electrode on the gate insulating layer, wherein the gate electrode includes a first gate electrode, and a second gate electrode, wherein each of the first gate electrode and the second gate electrode is spaced apart from the active layer and is disposed to face the active layer, the first gate electrode is in contact with the second gate electrode, and the first gate electrode has a work function different from a work function of the second gate electrode.

## Description

### CROSS-REFERENCE TO RELATED APPLICATIONS

This application claims the benefit of the Korean Patent Application No. 10-2024-0201861 filed on December 31, 2024, which is hereby incorporated by reference for all purposes as if fully set forth herein.

### Technical Field

The present disclosure relates to an apparatus and particularly to, for example, without limitation, a thin film transistor and a display apparatus comprising the same.

### Description of the Related art

As a thin film transistor may be manufactured on a glass substrate or a plastic substrate, the thin film transistor is widely used as a switching element or a driving element of a display apparatus such as a liquid crystal display device or an organic light emitting device.

According to a material constituting an active layer, the thin film transistor may be divided into an amorphous silicon thin film transistor in which amorphous silicon is used as an active layer, a polycrystalline silicon thin film transistor in which polycrystalline silicon is used as an active layer, and an oxide semiconductor thin film transistor in which oxide semiconductor is used as an active layer.

Among them, the oxide semiconductor thin film transistor having high mobility and having a large resistance change according to the content of oxygen has the advantage of easiness in obtaining desired physical properties. In the process of manufacturing the oxide semiconductor thin film transistor, the oxide constituting the active layer may be a film at a relatively low temperature, whereby a manufacturing cost is low. Also, due to the properties of oxide, the oxide semiconductor is transparent, whereby it is advantageous to implement a transparent display.

The description provided in the discussion of the related art section should not be assumed to be prior art merely because it is mentioned in or associated with that section. The discussion of the related art section may include information that describes one or more aspects of the subject technology, and the description in this section does not limit the disclosure.

### SUMMARY

A high-resolution display device includes a large number of thin film transistors. In order to arrange a large number of thin film transistors in a predetermined area, the size of the thin film transistor should be reduced. However, the inventors of the present disclosure have recognized that when the size of the thin film transistor is reduced, a channel length is also shortened, whereby driving stability of the thin film transistor may be lowered or deteriorated, thereby deteriorating display quality of the display device.

Therefore, various studies have been conducted to reduce or suppress deterioration of a small-sized thin film transistor and to improve reliability.

The present disclosure has been made in view of the above problems, and it is an object of the present disclosure to provide a technology capable of controlling a horizontal electric field intensity of a channel portion by a plurality of gate electrodes having different work functions.

It is another object of the present disclosure to provide a thin film transistor which reduces or suppresses a degradation in a drain edge region due to a drain voltage by a plurality of gate electrodes having different work functions.

It is another object of the present disclosure to provide a thin film transistor which improves driving stability by a plurality of gate electrodes having different work functions.

It is a further object of the present disclosure to provide a display apparatus including the thin film transistor.

In accordance with an aspect of the present disclosure, the above and other objects may be accomplished by the provision of a thin film transistor comprising an active layer including a channel portion, a gate insulating layer on the active layer, and a gate electrode on the gate insulating layer, wherein the gate electrode includes a first gate electrode, and a second gate electrode, wherein each of the first gate electrode and the second gate electrode is spaced apart from the active layer and is disposed to face the active layer, the first gate electrode is in contact with the second gate electrode, and the first gate electrode has a work function different from a work function of the second gate electrode.

The first gate electrode may have a first side and a second side opposite the first side, the second gate electrode may be in contact with the first side of the first gate electrode, and the second gate electrode may have a work function higher than that of the first gate electrode.

The difference between the work function of the second gate electrode and the work function of the first gate electrode may be 0.1eV or more.

The first gate electrode may include any one of titanium (Ti), aluminum (Al), nickel (Ni), chromium (Cr), and copper (Cu), and the second gate electrode may include any one of gold (Au) and platinum (Pt).

The first gate electrode may include any one of titanium (Ti), aluminum (Al), and nickel (Ni), and the second gate electrode may include any one of chromium (Cr), copper (Cu), gold (Au), and platinum (Pt).

According to one embodiment of the present disclosure, in case of an off state, a charge density of a region overlapping the second gate electrode in the channel portion and a charge density of a region overlapping the first gate electrode in the channel portion may be different from each other.

A charge density of a region overlapping the second gate electrode may be higher than a charge density of a region overlapping the first gate electrode.

According to one embodiment of the present disclosure, in case of an on state, a horizontal electric field intensity of a region overlapping the second gate electrode and a horizontal electric field intensity of a region overlapping the first gate electrode in the channel portion may be different from each other.

In the channel portion, a horizontal electric field intensity of a region overlapping the second gate electrode may be smaller than a horizontal electric field intensity of a region overlapping the first gate electrode.

According to another embodiment of the present disclosure, the first gate electrode may have a first side and a second side opposite the first side, the second gate electrode may be in contact with the second side of the first gate electrode, and the second gate electrode may have a work function lower than that of the first gate electrode.

The difference between the work function of the first gate electrode and the work function of the second gate electrode may be 0.1eV or more.

The first gate electrode may include any one of gold (Au) and platinum (Pt), and the second gate electrode may include any one of titanium (Ti), aluminum (Al), nickel (Ni), chromium (Cr), and copper (Cu).

The first gate electrode may include any one of chromium (Cr), copper (Cu), gold (Au), and platinum (Pt), and the second gate electrode may include any one of titanium (Ti), aluminum (Al), and nickel (Ni).

According to another embodiment of the present disclosure, the gate electrode may further include a third gate electrode, wherein the third gate electrode may be spaced apart from the active layer and may be disposed to face the active layer, the third gate electrode may be in contact with the second side of the first gate electrode, and the third gate electrode may have a work function lower than that of the second gate electrode.

The third gate electrode may have a work function lower than that of the first gate electrode.

The difference between the work function of the second gate electrode and the work function of the first gate electrode may be 0.1eV or more, and the difference between the work function of the first gate electrode and the work function of the third gate electrode may be 0.1eV or more.

The second gate electrode may include any one of gold (Au) and platinum (Pt), and each of the first gate electrode and the third gate electrode may include any one of titanium (Ti), aluminum (Al), nickel (Ni), chromium (Cr), and copper (Cu).

The second gate electrode may include any one of chromium (Cr) and copper (Cu), and each of the first gate electrode and the third gate electrode may include any one of titanium (Ti), aluminum (Al), and nickel (Ni).

The first gate electrode may include any one of chromium (Cr) and copper (Cu), the second gate electrode may include any one of gold (Au) and platinum (Pt), and the third gate electrode may include any one of titanium (Ti), aluminum (Al), and nickel (Ni).

According to another embodiment of the present disclosure, in case of an off state, a charge density of a region overlapping the first gate electrode in the channel portion, a charge density of a region overlapping the second gate electrode in the channel portion, and a charge density of a region overlapping the third gate electrode in the channel portion may be different from each other.

In the channel portion, a charge density of a region overlapping the second gate electrode may be higher than a charge density of a region overlapping the first gate electrode, and a charge density of a region overlapping the first gate electrode may be higher than a charge density of a region overlapping the third gate electrode.

According to another embodiment of the present disclosure, in case of an on state, a horizontal electric field intensity of a region overlapping the second gate electrode in the channel portion and a horizontal electric field intensity of a region overlapping the third gate electrode in the channel portion may be different from each other.

In the channel portion, a horizontal electric field intensity of a region overlapping the second gate electrode may be smaller than a horizontal electric field intensity of a region overlapping the third gate electrode.

According to another embodiment of the present disclosure, it may provide a display apparatus including the thin film transistor.

In addition to the effects of the present disclosure as mentioned above, additional advantages and features of the present disclosure will be clearly understood by those skilled in the art from the above description of the present disclosure.

It is to be understood that both the foregoing general description and the following detailed description are exemplary and explanatory and are intended to provide further explanation of the inventive concepts as claimed.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a plan view of a thin film transistor according to one embodiment of the present disclosure;
FIG. 2 is a schematic cross-sectional view taken along line I-I' of FIG. 1 according to one embodiment of the present disclosure;
FIG. 3 is a schematic graph showing a charge density of an active layer of a thin film transistor according to a comparative example;
FIG. 4 is a schematic graph showing a charge density for each region of an active layer of a thin film transistor according to one embodiment of the present disclosure;
FIG. 5 is a graph showing a work function for each type of metal;
FIG. 6 is a schematic cross-sectional view of a thin film transistor according to another embodiment of the present disclosure;
FIG. 7 is a schematic cross-sectional view of a thin film transistor according to another embodiment of the present disclosure;
FIG. 8 is a schematic graph showing a charge density for each region of an active layer of a thin film transistor according to another embodiment of the present disclosure;
FIG. 9 is a schematic cross-sectional view of a thin film transistor according to another embodiment of the present disclosure;
FIG. 10 is a schematic view of a display apparatus according to another embodiment of the present disclosure; and
FIG. 11 is a circuit diagram of one pixel of FIG. 10.

### DETAILED DESCRIPTION OF THE DISCLOSURE

Advantages and features of the present disclosure, and implementation methods thereof will be clarified through the following embodiments, described with reference to the accompanying drawings. The present disclosure may, however, be embodied in different forms and should not be construed as being limited to the embodiments set forth herein. Rather, these embodiments are provided so that this disclosure will be thorough and complete, and will fully convey the scope of the present disclosure to those skilled in the art. Further, the present disclosure is only defined by the scope of the claims.

The shapes, sizes, ratios, angles, and numbers disclosed in the drawings for describing embodiments of the present disclosure are merely examples, and thus the present disclosure is not limited to the illustrated details. Like reference numerals refer to like elements throughout. In the following description, when the detailed description of the relevant known function or configuration is determined to unnecessarily obscure the important point of the present disclosure, the detailed description will be omitted.

In the case in which "comprise," "have," and "include" described in the present specification are used, another part may also be present unless "only" is used. The terms in a singular form may include plural forms unless noted to the contrary.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

Spatially relative terms such as "below or beneath", "lower", "above", "upper" and the like may be used herein to describe a relationship between one element or structure and other elements or structures with easiness. It will be understood that the spatially relative terms are intended to include different orientations of the device in use or operation in addition to the orientation described in the figures. For example, if the device in the figures is turned over, elements described as "below or beneath" other elements or structures would then be oriented "above" the other elements or structures. Thus, the exemplary term "below" may include both lower and upper directions. Likewise, the exemplary term "above or upper" may include both upper and lower directions.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element, without departing from the scope of the present disclosure.

It should be understood that the term "at least one" includes all combinations related with any one item. For example, "at least one among a first element, a second element and a third element" may include all combinations of two or more elements selected from the first, second and third elements as well as each element of the first, second and third elements.

Features of various embodiments of the present disclosure may be partially or overall coupled to or combined with each other and may be variously inter-operated with each other and driven technically as those skilled in the art can sufficiently understand. The embodiments of the present disclosure may be carried out independently from each other or may be carried out together in a co-dependent relationship.

In the drawings, the same or similar elements are denoted by the same reference numerals even though they are depicted in different drawings.

Any implementation described herein as an "example" is not necessarily to be construed as preferred or advantageous over other implementations.

When an element or layer is "connected," "coupled," or "adhered" to another element or layer denotes that the element or layer can not only be directly connected or adhered to the other element or layer, but also be indirectly connected or adhered to the other element or layer with one or more intervening elements or layers "disposed," or "interposed" between the elements or layers, unless otherwise specified. It should be understood to mean that elements may be so disposed to directly contact each other, or may be so disposed without directly contacting each other.

The expression of a first element, a second elements "and/or" a third element should be understood as one of the first, second and third elements or as any or all combinations of the first, second and third elements. By way of example, A, B and/or C can refer to only A; only B; only C; any or some combination of A, B, and C; or all of A, B, and C.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

In the embodiments of the present disclosure, a source electrode and a drain electrode are distinguished from each other, for convenience of explanation. However, the source electrode and the drain electrode are used interchangeably. Also, the source electrode in any one embodiment of the present disclosure may be the drain electrode in another embodiment of the present disclosure, and the drain electrode in any one embodiment of the present disclosure may be the source electrode in another embodiment of the present disclosure.

In one or more embodiments of the present disclosure, for convenience of explanation, a source connection portion is distinguished from a source electrode, and a drain connection portion is distinguished from a drain electrode. However, embodiments of the present disclosure are not limited to this structure. For example, a source connection portion may be a source electrode, and a drain connection portion may be a drain electrode. Also, a source connection portion may be a drain electrode, and a drain connection portion may be a source electrode.

In one or more embodiments of the present disclosure, a region in which the source electrode is in contact may be referred to as a source region, a region in which the drain electrode is in contact may be referred to as a drain region, and a region disposed between the source region and the drain region may be referred to as a channel region.

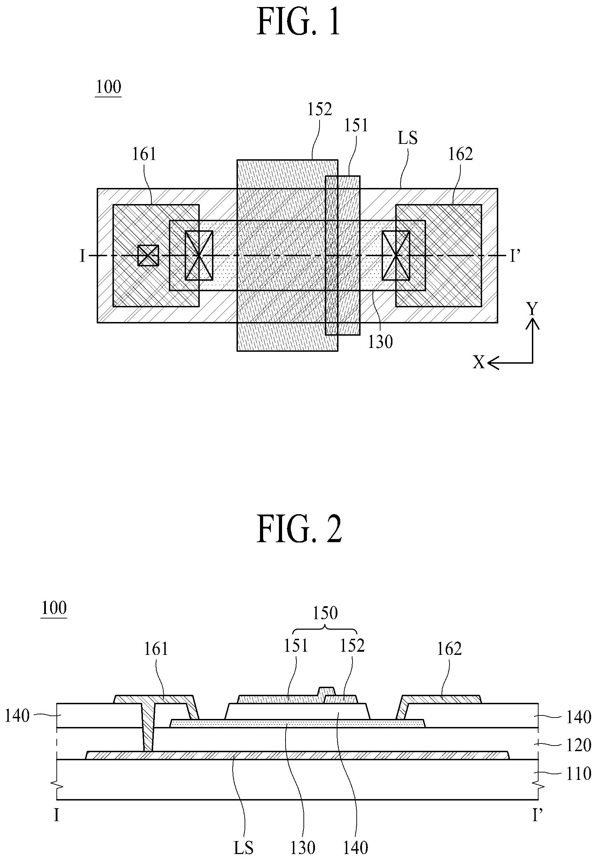

FIG. 1 is a plan view of a thin film transistor 100 according to one embodiment of the present disclosure, and FIG. 2 is a schematic cross-sectional view of the thin film transistor 100 taken along line I-I' of FIG. 1.

Referring to FIGs. 1 and 2, the thin film transistor 100 according to one embodiment of the present disclosure includes an active layer including a channel portion, a gate insulating layer on the active layer, and a gate electrode on the gate insulating layer. The gate electrode includes a first gate electrode and a second gate electrode. Each of the first gate electrode and the second gate electrode is spaced apart from the active layer and is disposed to face the active layer. The first gate electrode is in contact with the second gate electrode. The first gate electrode has a work function which is different from that of the second gate electrode.

Referring to FIG. 2, the thin film transistor 100 may be disposed on a substrate 110.

The substrate 110 supports components of the thin film transistor 100. Any structure supporting the thin film transistor 100 may be referred to as the substrate 110 without limitation.

A glass substrate or a polymer resin substrate may be used as the substrate 110. The polymer resin substrate may be a plastic substrate. The plastic substrate may include at least one having a flexible property of polyimide (PI), polycarbonate (PC), polyethylene (PE), polyester, polyethylene terephthalate (PET), and polystyrene (PS). When the plastic is used for the substrate 110, heat-resistant plastic capable of withstanding high temperatures may be used in consideration of a deposition process performed on the substrate 110 at a high temperature.

A light shielding layer LS may be disposed on the substrate 110. The light shielding layer LS may have a light blocking property. The light shielding layer LS may block light incident from the substrate 110, thereby protecting the channel portion 131 of the active layer 130.

The light shielding layer LS may be made of a material having the light blocking property. The light shielding layer LS may include at least one of aluminum-based metal such as aluminum (Al) or an aluminum alloy, molybdenum-based metal such as molybdenum (Mo) or molybdenum alloy, chromium (Cr), tantalum (Ta), neodymium (Nd), titanium (Ti), and iron (Fe).

According to one embodiment of the present disclosure, the light shielding layer LS may have electrical conductivity. The light shielding layer LS may be electrically connected to any one of a source electrode 161 and a drain electrode 162. Referring to FIG. 2, for example, the light shielding layer LS may be connected to the source electrode 161.

A buffer layer 120 is disposed on the light shielding layer LS. The buffer layer 120 covers an upper surface of the substrate 110 and an upper surface of the light shielding layer LS. The buffer layer 120 has an insulating property and protects the active layer 130.

The buffer layer 120 may be formed of an inorganic material or an organic material. For example, the buffer layer 120 may include an insulating oxide such as silicon oxide (SiOx), aluminum oxide (Al₂O₃), or the like.

The buffer layer 120 may protect the active layer 130 by blocking impurities such as moisture and oxygen introduced from the substrate 110, may planarize an upper portion of the base substrate 110, and may be formed as a single layer or a plurality of layers.

Referring to FIG. 2, the active layer 130 may include the channel portion 130n, a source connection portion 131, and a drain connection portion 132. The source connection portion 131 may be in contact with the source electrode 161. The drain connection portion 132 may be in contact with the drain electrode 162.

The active layer 130 is disposed on the buffer layer 120 and is configured to include an oxide semiconductor material. According to one embodiment of the present disclosure, for example, the active layer 130 may be an oxide semiconductor layer made of an oxide semiconductor material.

For example, the active layer 130 may include at least one of IGZO(InGaZnO)-based oxide semiconductor material, IGO(InGaO)-based oxide semiconductor material, IGZTO(InGaZnSnO)-based oxide semiconductor material, GZTO(GaZnSnO)-based oxide semiconductor material, GZO(GaZnO)-based oxide semiconductor material, GO(GaO)-based oxide semiconductor material, TO(SnO)-based oxide semiconductor material, ITO(InSnO)-based oxide semiconductor material, ITZO(InSnZnO)-based oxide semiconductor material, IZO(InZnO)-based oxide semiconductor material, ZO(ZnO)-based oxide semiconductor material, IO(InO)-based oxide semiconductor material, InO(InO)-based oxide semiconductor material, ZnO-based oxide semiconductor material, and FIZO(FeInZnO)-based oxide semiconductor material.

The active layer 130 may have a single-layered structure or a multi-layered structure including two or more oxide semiconductor layers.

A gate insulating layer 140 is disposed on the active layer 130.

According to one embodiment of the present disclosure, the gate insulating layer 140 may be disposed to cover the entire upper surface of the active layer 130. The gate insulating layer 140 may be disposed to cover an entire upper surface of the active layer 130 and may be disposed to cover an entire upper surface of the buffer layer 120.

The gate insulating layer 140 may be made of an insulating material including hydrogen (H). For example, the material for forming the gate insulating layer 140 may include hydrogen (H). Therefore, according to one embodiment of the present disclosure, the gate insulating layer 140 may include hydrogen (H).

For example, the gate insulating layer 140 may include at least one of silicon oxide (SiOₓ), silicon nitride (SiNₓ), and aluminum oxide (AlOₓ).

The silicon oxide (SiOₓ) may be formed under a condition including silane (SiH₄) and oxygen (O₂). Accordingly, the gate insulating layer 140 including silicon oxide (SiOₓ) may include hydrogen.

The silicon nitride (SiNₓ) may be formed under a condition including silane (SiH₄), ammonia (NH₃), and oxygen (O₂). Accordingly, the gate insulating layer 140 including silicon nitride (SiNₓ) may include hydrogen.

The aluminum oxide (AlOₓ) may be formed under a condition including an aluminum compound, a hydroxyl group (OH), or moisture (H₂O). Accordingly, the gate insulating layer 140 including aluminum oxide (AlOₓ) may include hydrogen.

However, one embodiment of the present disclosure is not limited thereto, and other insulating materials generally known may be applied to the gate insulating layer 140.

According to one embodiment of the present disclosure, a gate electrode 150 is disposed on the gate insulating layer 140. The gate electrode 150 is spaced apart from the active layer 130 and is configured to at least partially overlap the active layer 130. In the active layer 130, a portion overlapping the gate electrode 150 may be referred to as the channel portion.

The gate electrode 150 may include the first gate electrode 151 and the second gate electrode 152.

The first gate electrode 151 and the second gate electrode 152 may be spaced apart from the active layer 130 with respect to the gate insulating layer 140, respectively. More specifically, each of the first gate electrode 151 and the second gate electrode 152 may be spaced apart from the active layer 130 with respect to the gate insulating layer 140 and may be disposed to face the active layer 130.

The first gate electrode 151 may include a first side and a second side, wherein the second side is opposite to the first side. The first side of the first gate electrode 151 refers to a region facing a drain region with respect to the center of the first gate electrode 151. The second side of the first gate electrode 151 refers to a region facing a source region with respect to the center of the first gate electrode 151.

The first gate electrode 151 may be in contact with the second gate electrode 152. The first gate electrode 151 may be disposed in parallel with the second gate electrode 152 while being in contact with the second gate electrode 152. More specifically, the first side of the first gate electrode 151 may be disposed in parallel with the second gate electrode 152 while being in contact with the second gate electrode 152. Alternatively, the second side of the first gate electrode 151 may be disposed in parallel with the second gate electrode 152 while being in contact with the second gate electrode 152.

The first gate electrode 151 may be disposed to overlap at least a portion of the second gate electrode 152. More specifically, the first side of the first gate electrode 151 may be disposed to overlap the second gate electrode 152. Alternatively, the second side of the first gate electrode 151 may be disposed to overlap the second gate electrode 152.

Referring to FIG. 2, the first gate electrode 151 according to one embodiment of the present disclosure may be formed to overlap at least a portion of the second gate electrode 152. More specifically, the first gate electrode 151 may be configured to overlap at least a portion of the second gate electrode 152 and may be formed on at least a portion of the second gate electrode 152.

The source electrode 161 and the drain electrode 162 are disposed on the gate insulating layer 140 while being spaced apart from the gate electrode 150. More specifically, the source electrode 161 may be disposed in the source region while being spaced apart from the gate electrode 150, and the drain electrode 162 may be disposed in the drain region while being spaced apart from the gate electrode 150.

The source electrode 161 and the drain electrode 162 are spaced apart from each other and are connected to the active layer 130, respectively. More specifically, the source electrode 161 and the drain electrode 162 may be formed on the gate insulating layer 140 while being spaced apart from each other with respect to the gate electrode 150 and may be connected to the active layer 130 through a contact hole, respectively.

Each of the source electrode 161 and the drain electrode 162 may include at least one of molybdenum (Mo), aluminum (Al), chrome (Cr), gold (Au), titanium (Ti), nickel (Ni), neodymium (Nd), copper (Cu), and an alloy thereof. Each of the source electrode 161 and the drain electrode 162 may be formed of a single layer made of metal or alloy thereof or may be formed of two or more layers.

An interlayer insulating layer (not shown) may be disposed on the gate electrode 150, the source electrode 161, and the drain electrode 162. Also, an interlayer insulating layer may be disposed in a contact hole region in which each of the source electrode 161 and the drain electrode 162 contacts the active layer 130. The interlayer insulating layer is an insulating layer formed of an insulating material. The interlayer insulating layer may be formed of an organic material, may be formed of an inorganic material or may be formed of a deposition structure of an organic material layer and an inorganic material layer.

According to one embodiment of the present disclosure, the first gate electrode 151 may have a work function different from that of the second gate electrode 152.

The work function is the energy difference between the energy level that deviates from the electric force of material and the highest energy level (Fermi level) when electrons in the material are filled from the low energy level.

When the work function of the gate electrode 150 is different, the Fermi level is also different. Thus, even though the same voltage is applied thereto, the charge density in the channel portion 130n overlapping the gate electrode 150 may vary. Thus, the electric field formed in the channel portion 130n may vary.

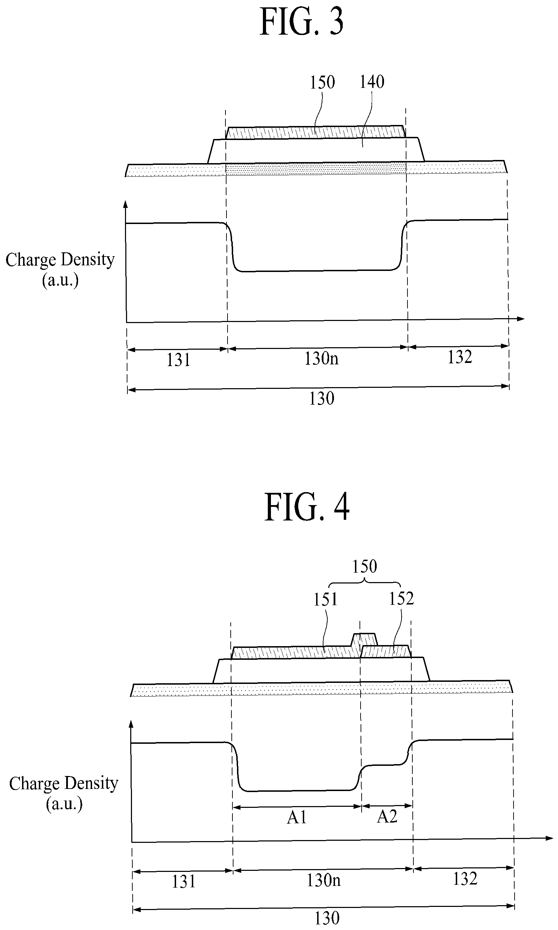

FIG. 3 is a schematic graph showing a charge density of an active layer when a thin film transistor according to a comparative example is in an off state (or turned-off).

According to one embodiment of the present disclosure, in the channel portion 130n, a region adjacent to the source connection portion 131 may be defined as a source edge region, and a region adjacent to the drain connection portion 132 may be defined as a drain edge region.

Referring to FIG. 3, a thin film transistor according to a comparative example having a single gate electrode 150 has a large horizontal electric field in a source edge region and a drain edge region. Among these, since a high voltage is applied to a drain connection portion 132, a stress by the voltage is severe in the drain edge region between the drain connection portion 132 and a channel portion 130n. Accordingly, in the thin film transistor according to a comparative example, the drain edge region may be deteriorated. When the thin film transistor is included in a display apparatus, it may have problems related with deterioration of display quality or lifespan reduction in the display apparatus.

On the other hand, the thin film transistor 100 according to one embodiment of the present disclosure includes the second gate electrode 152 having a work function different from that of the first gate electrode 151. More specifically, the second gate electrode 152 may contact the first side of the first gate electrode 151 and may have the work function which is higher than that of the first gate electrode 151.

FIG. 4 is a schematic graph showing a charge density for each region of the active layer 130 when the thin film transistor 100 according to one embodiment of the present disclosure is in an off state.

Referring to FIG. 4, when the thin film transistor 100 according to one embodiment of the present disclosure is in an off state, a charge density of a region A2 overlapping the second gate electrode 152 in the channel portion 130n may be different from a charge density of a region A1 overlapping the first gate electrode 151 in the channel portion 130n. More specifically, when the thin film transistor 100 according to one embodiment of the present disclosure is in the off state, the charge density of the region A2 overlapping the second gate electrode 152 in the channel portion 130n may be higher than the charge density of the region A1 overlapping the first gate electrode 151 in the channel portion 130n.

When the thin film transistor 100 according to one embodiment of the present disclosure having the charge density is in an on state (or turned-on), a horizontal electric field intensity of the region A2 overlapping the second gate electrode 152 having the large charge density may be different from a horizontal electric field intensity of the region A1 overlapping the first gate electrode 151. More specifically, when the thin film transistor 100 is in the on state, the horizontal electric field intensity of the region A2 overlapping the second gate electrode 152 having the large charge density may be relatively smaller than the horizontal electric field intensity of the region A1 overlapping the first gate electrode 151. Accordingly, even when the large voltage is applied to the drain connection portion 132, a stress by the voltage in the drain edge region between the drain connection portion 132 and the channel portion 130n may be reduced. Thus, the degradation of the drain edge region by the drain voltage may be reduced or suppressed. When the thin film transistor 100 is included in the display apparatus 500, the display apparatus 500 may have excellent display quality and long lifespan property.

According to one embodiment of the present disclosure, the difference between the work function of the second gate electrode 152 and the work function of the first gate electrode 151 may be 0.1eV or more.

More specifically, the difference between the work function of the second gate electrode 152 and the work function of the first gate electrode 151 may be 0.1eV or more, may be 0.2eV or more, may be 0.3eV or more, may be 0.4eV or more or may be 0.5eV or more.

According to one embodiment of the present disclosure, when the second gate electrode 152 has a work function higher than the first gate electrode 151 by more than 0.1eV, the degradation in the drain edge region by the drain voltage may be reduced or suppressed.

When the difference between the work function of the second gate electrode 152 and the work function of the first gate electrode 151 is less than 0.1eV, it may be difficult to reduce or suppress the degradation in the drain edge region by the drain voltage.

According to one embodiment of the present disclosure, the gate electrode 150 may include at least one of titanium (Ti), aluminum (Al), nickel (Ni), chromium (Cr), copper (Cu), gold (Au), and platinum (Pt).

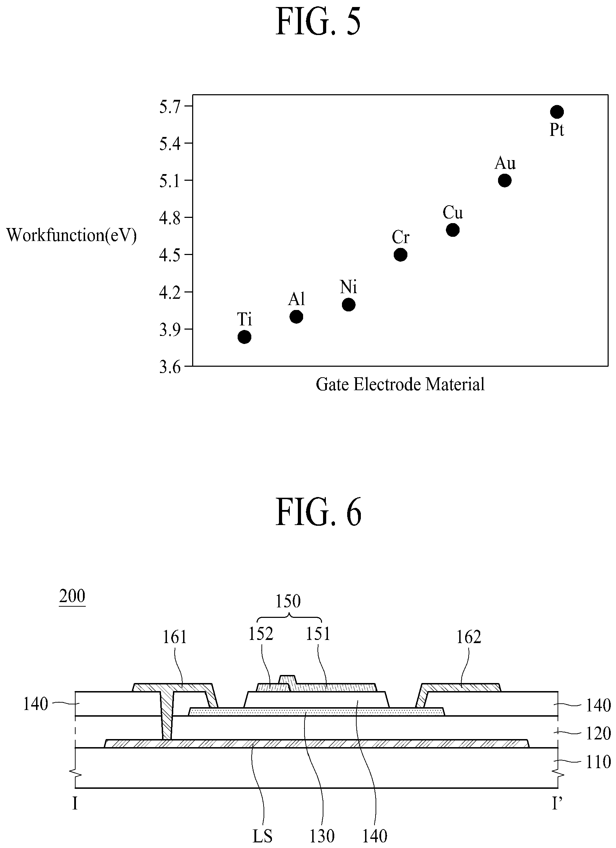

FIG. 5 is a work function graph for each type of metal measured by a Kelvin Probe Measurement (KPM) method.

Referring to FIG. 5, it may check the difference of the work function among titanium (Ti), aluminum (Al), nickel (Ni), chromium (Cr), copper (Cu), gold (Au), and platinum (Pt).

According to one embodiment of the present disclosure, the second gate electrode 152 may be designed to include metal having a work function higher than that of the first gate electrode 151 so as to reduce or suppress the occurrence of deterioration in the drain edge region by the drain voltage.

According to one embodiment of the present disclosure, the first gate electrode 151 may include any one of titanium (Ti), aluminum (Al), nickel (Ni), chromium (Cr), and copper (Cu), and the second gate electrode 152 may include any one of gold (Au) and platinum (Pt).

According to one embodiment of the present disclosure, the first gate electrode 151 may include any one metal of titanium (Ti), aluminum (Al), and nickel (Ni), and the second gate electrode 152 may include any one metal of chromium (Cr), copper (Cu), gold (Au), and platinum (Pt).

However, a description of a combination of the metal included in the first gate electrode 151 and the second gate electrode 152 is an example, and the present disclosure is not limited thereto.

FIG. 6 is a schematic cross-sectional view of a thin film transistor 200 according to another embodiment of the present disclosure.

Hereinafter, in order to avoid redundancy, a description of the above-described components will be omitted, or the above-described components will be briefly described.

Referring to FIG. 6, the thin film transistor 200 according to another embodiment of the present disclosure may include a first gate electrode 151 and a second gate electrode 152, and the second gate electrode 152 may be in contact with a second side of the first gate electrode 151. The second gate electrode 152 may have a work function lower than that of the first gate electrode 151.

Referring to FIG. 6, for example, when the second gate electrode 152 contacting the second side of the first gate electrode 151 has a work function lower than that of the first gate electrode 151, the first gate electrode 151 has a work function higher than that of the second gate electrode 152. Therefore, in the thin film transistor 200 according to another embodiment of the present disclosure, a horizontal electric field intensity in a drain edge region may be reduced. Accordingly, the degradation occurrence in the drain edge region by the drain voltage may be reduced or suppressed.

According to another embodiment of the present disclosure, the difference between the work function of the first gate electrode 151 and the work function of the second gate electrode 152 may be 0.1eV or more.

More specifically, the difference between the work function of the first gate electrode 151 and the work function of the second gate electrode 152 may be 0.1eV or more, may be 0.2eV or more, may be 0.3eV or more, may be 0.4eV or more or may be 0.5eV or more.

When the difference between the work function of the first gate electrode 151 and the work function of the second gate electrode 152 is less than 0.1eV, it may be difficult to reduce or suppress an occurrence of deterioration in the drain edge region by the drain voltage.

According to another embodiment of the present disclosure, the first gate electrode 151 may be designed to include metal having a work function higher than that of the second gate electrode 152 so as to reduce or suppress the occurrence of deterioration in the drain edge region by the drain voltage.

For example, the first gate electrode 151 may include metal having a work function higher than that of the second gate electrode 152 in the metal of FIG. 5. More specifically, the first gate electrode 151 may include metal having a work function higher than that of the second gate electrode 152 in the metal of FIG. 5.

According to another embodiment of the present disclosure, the first gate electrode 151 may include any one of gold (Au) and platinum (Pt), and the second gate electrode 152 may include any one of titanium (Ti), aluminum (Al), nickel (Ni), chromium (Cr), and copper (Cu).

According to another embodiment of the present disclosure, the first gate electrode 151 may include any one metal of chromium (Cr), copper (Cu), gold (Au), and platinum (Pt), and the second gate electrode may include any one metal of titanium (Ti), aluminum (Al), and nickel (Ni).

However, a description of a combination of the metal included in the first gate electrode 151 and the second gate electrode 152 is an example, and the present disclosure is not limited thereto.

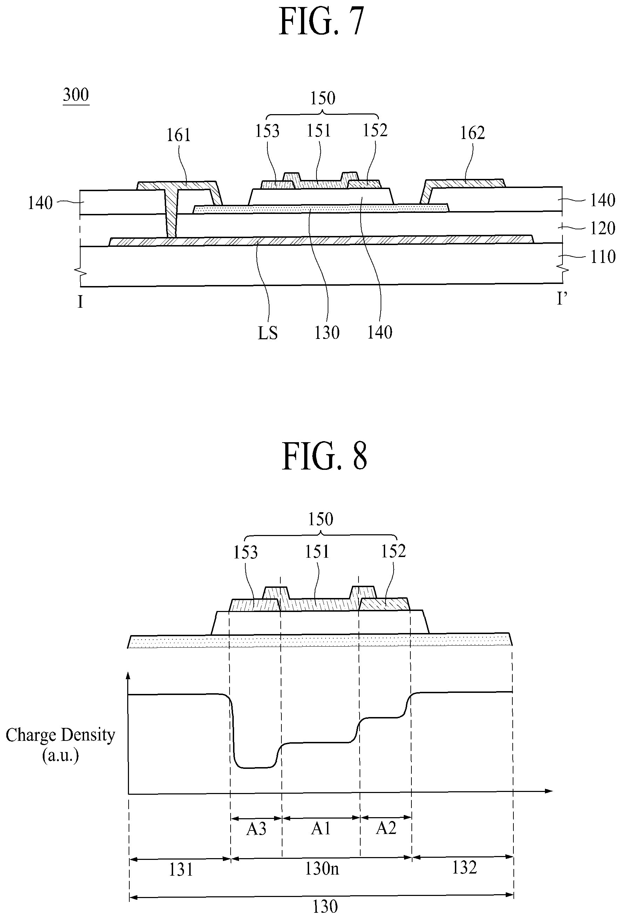

FIG. 7 is a schematic cross-sectional view of a thin film transistor 300 according to another embodiment of the present disclosure.

The thin film transistor 300 according to another embodiment of the present disclosure may further include a third gate electrode 153 in addition to a first gate electrode 151 and a second gate electrode 152.

Each of the first gate electrode 151, the second gate electrode 152, and the third gate electrode 153 may be spaced apart from an active layer 130 with respect to a gate insulating layer 140. More specifically, each of the first gate electrode 151, the second gate electrode 152, and the third gate electrode 153 may be spaced apart from the active layer 130 with respect to the gate insulating layer 140 while being opposite to the active layer 130.

The first gate electrode 151 may be in contact with the second gate electrode 152. The first gate electrode 151 may be disposed in parallel with the second gate electrode 152 while being in contact with the second gate electrode 152. More specifically, a first side of the first gate electrode 151 may be disposed in parallel with the second gate electrode 152 while being in contact with the second gate electrode 152.

The first gate electrode 151 may be disposed to overlap at least a portion of the second gate electrode 152. More specifically, the first side of the first gate electrode 151 may be disposed to overlap the second gate electrode 152.

The third gate electrode 153 may be in contact with the first gate electrode 151. The third gate electrode 153 may be disposed in parallel with the first gate electrode 151 while being in contact with the first gate electrode 151. More specifically, the third gate electrode 153 may be disposed in parallel in contact with a second side of the first gate electrode 151.

The third gate electrode 153 may be disposed to overlap at least a portion of the first gate electrode 151. More specifically, the third gate electrode 153 may be disposed to overlap the second side of the first gate electrode 151.

According to another embodiment of the present disclosure, the second gate electrode 152 may have a work function higher than that of the first gate electrode 151, and the second gate electrode 153 may have a work function higher than that of the third gate electrode 153.

FIG. 8 is a schematic graph showing a charge density for each region of the active layer 130 when the thin film transistor 300 according to another embodiment of the present disclosure is in an off state.

Referring to FIG. 8, when the thin film transistor 300 according to another embodiment of the present disclosure is in an off state, in a channel portion 130n, a charge density of a region A1 overlapping the first gate electrode 151, a charge density of a region A2 overlapping the second gate electrode 152, and a charge density of a region A3 overlapping the third gate electrode 153 may be different from one another. More specifically, when the thin film transistor 300 according to another embodiment of the present disclosure is in the off state, in the channel portion 130n, the charge density of the region A2 overlapping the second gate electrode 152 may be higher than the charge density of the region A1 overlapping the first gate electrode 151, and the charge density of the region A1 overlapping the first gate electrode 151 may be higher than the charge density of the region A3 overlapping the third gate electrode 153.

When the thin film transistor 300 according to another embodiment of the present disclosure having the charge density is in the on state, a horizontal electric field intensity of the region A2 overlapping the second gate electrode 152 having the large charge density may be different from a horizontal electric field intensity of the region A3 overlapping the third gate electrode 153. More specifically, when the thin film transistor 100 is in the on state, the horizontal electric field intensity of the region A2 overlapping the second gate electrode 152 having the large charge density may be relatively smaller than the horizontal electric field intensity of the region A3 overlapping the third gate electrode 153. Accordingly, even when a large voltage is applied to a drain connection portion 132, a stress by the voltage in a drain edge region between the drain connection portion 132 and the channel portion 130n may be reduced. Thus, the degradation of the drain edge region by the drain voltage may be reduced or suppressed. When the thin film transistor 300 is included in a display apparatus 500, the display apparatus 500 may have excellent display quality and long lifespan property.

According to another embodiment of the present disclosure, the third gate electrode 153 may have a work function lower than that of the first gate electrode 151.

According to another embodiment of the present disclosure, in the channel portion 130n, the region A3 overlapping the third gate electrode 153 has a predetermined horizontal electric field. More specifically, the horizontal electric field intensity of the region A3 overlapping the third gate electrode 153 is relatively larger than the horizontal electric field intensity of the region A2 overlapping the second gate electrode. However, since a voltage lower than that of the drain connection portion 132 is applied to a source connection portion 131, a stress due to the voltage is small in a source edge region between the source connection portion 131 and the channel portion 130n. Therefore, in the thin film transistor 300 according to another embodiment of the present disclosure, the deterioration in the source edge region may not occur.

According to another embodiment of the present disclosure, in the channel portion 130n, since the region A3 overlapping the third gate electrode 153 has a low charge density, it may perform the same function as the channel portion 130n in all regions except for a partial region adjacent to the source connection portion 131. In the channel portion 130n, the region A3 overlapping the third gate electrode 153 may perform the same function as the channel portion 130n in all regions except for a partial region adjacent to the source connection portion 131, whereby it may have an effect of increasing an effective channel length.

In addition, since the region A3 overlapping the third gate electrode 153 has a low charge density, an effect of increasing a threshold voltage may be generated, and a negative shift (minus shift (-)) of the threshold voltage may be prevented or reduced. Therefore, as the thin film transistor 300 according to another embodiment of the present disclosure includes the third gate electrode 153 having a work function lower than that of the first gate electrode 151, driving stability may be improved.

According to another embodiment of the present disclosure, the difference between the work function of the second gate electrode 152 and the work function of the first gate electrode 151 may be 0.1eV or more.

More specifically, the difference between the work function of the second gate electrode 152 and the work function of the first gate electrode 151 may be 0.1eV or more, may be 0.2eV or more, may be 0.3eV or more, may be 0.4eV or more or may be 0.5eV or more.

According to another embodiment of the present disclosure, when the second gate electrode 152 has a work function higher than the first gate electrode 151 by more than 0.1eV, the degradation in the drain edge region by the drain voltage may be reduced or suppressed.

When the difference between the work function of the second gate electrode 152 and the work function of the first gate electrode 151 is less than 0.1eV, it may be difficult to reduce or suppress the degradation in the drain edge region by the drain voltage.

According to another embodiment of the present disclosure, the difference between the work function of the first gate electrode 151 and the work function of the third gate electrode 153 may be 0.1eV or more.

More specifically, the difference between the work function of the first gate electrode 151 and the work function of the third gate electrode 153 may be 0.1eV or more, may be 0.2eV or more, may be 0.3eV or more, may be 0.4eV or more or may be 0.5eV or more.

According to another embodiment of the present disclosure, when the third gate electrode 153 has a work function lower than the first gate electrode 151 by more than 0.1eV, the region A3 of the channel portion 130n overlapping the third gate electrode 153 has a low charge density, whereby it may perform the same function as the channel portion 130n in all regions except for a partial region adjacent to the source connection portion 131.

In addition, since the region A3 overlapping the third gate electrode 153 has a low charge density, an effect of increasing a threshold voltage may be generated, and a negative shift (minus shift (-)) of the threshold voltage may be prevented or reduced. Therefore, as the thin film transistor 300 according to another embodiment of the present disclosure includes the third gate electrode 153 having a work function lower than that of the first gate electrode 151 by more than 0.1eV, driving stability may be improved.

When the difference between the work function of the first gate electrode 151 and the work function of the third gate electrode 153 is less than 0.1eV, the threshold voltage may not be sufficiently high.

According to another embodiment of the present disclosure, the second gate electrode 152 may be designed to include metal having a work function higher than that of the first gate electrode 151 and the third gate electrode 153 in order to reduce or suppress the occurrence of deterioration in the drain edge region by the drain voltage.

According to another embodiment of the present disclosure, the second gate electrode 152 may include any one metal of gold (Au) and platinum (Pt), and each of the first gate electrode 151 and the third gate electrode 153 may include any one metal of titanium (Ti), aluminum (Al), nickel (Ni), chromium (Cr), and copper (Cu).

According to another embodiment of the present disclosure, the second gate electrode 152 may include any one metal of chromium (Cr), copper (Cu), gold (Au), and platinum (Pt), and each of the first gate electrode 151 and the third gate electrode 153 may include any one metal of titanium (Ti), aluminum (Al), and nickel (Ni).

According to another embodiment of the present disclosure, the third gate electrode 153 may include metal having a work function lower than that of the first gate electrode 151 so as to prevent or reduce the negative shift (minus shift (-)) of the threshold voltage by the increase in the threshold voltage.

According to another embodiment of the present disclosure, the second gate electrode 152 may include any one metal of gold (Au) and platinum (Pt), the first gate electrode 151 may include any one metal of chromium (Cr) and copper (Cu), and the third gate electrode 153 may include any one metal of titanium (Ti), aluminum (Al), and nickel (Ni).

However, a description of a combination of the metal included in the first gate electrode 151, the second gate electrode 152, and the third gate electrode 153 is an example, and the present disclosure is not limited thereto.

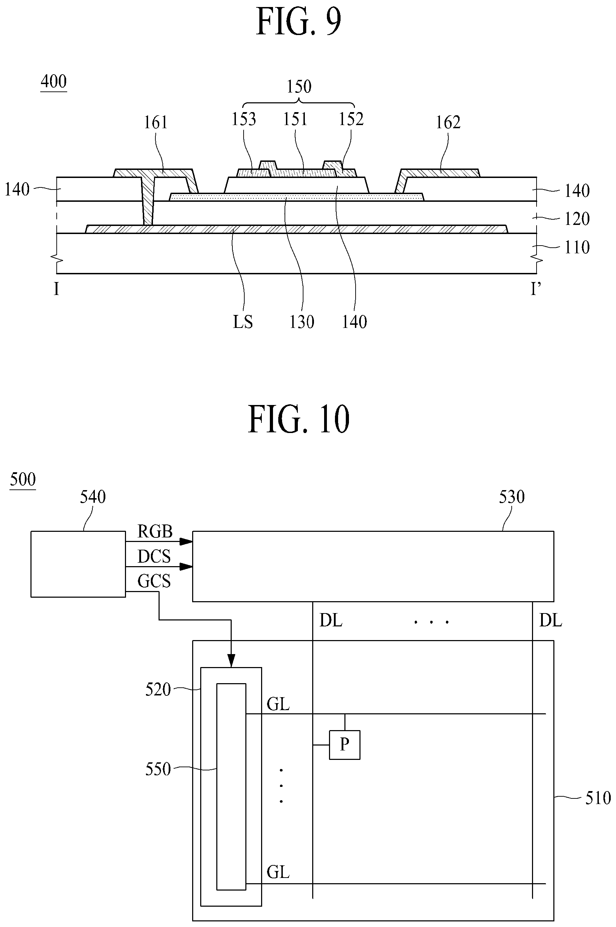

FIG. 9 is a schematic cross-sectional view of a thin film transistor 400 according to another embodiment of the present disclosure.

Referring to FIG. 9, the thin film transistor 400 according to another embodiment of the present disclosure may include a first gate electrode 151, a second gate electrode 152, and a third gate electrode 153. The second gate electrode 152 may contact a first side of the first gate electrode 151 and may have a work function higher than that of the first gate electrode 151. The third gate electrode 153 may contact a second side of the first gate electrode 151 and may have a work function lower than that of the first gate electrode 151.

According to another embodiment of the present disclosure, at least a portion of the first gate electrode 151 may be formed to overlap at least a portion of the third gate electrode 153. In addition, at least a portion of the second gate electrode 152 may be formed to overlap at least a portion of the first gate electrode 151.

Accordingly, the thin film transistor 400 according to another embodiment of the present disclosure may reduce or suppress the degradation in the drain edge region by the drain voltage and may improve driving stability.

Another embodiment of the present disclosure provides a display apparatus 500 including at least one of the thin film transistors 100, 200, 300, and 400 described above.

FIG. 10 is a schematic diagram of a display apparatus 500 according to another embodiment of the present disclosure.

As shown in FIG. 10, the display apparatus 500 according to another embodiment of the present disclosure includes a display panel 510, a gate driver 520, a data driver 530, and a controller 540.

Gate lines GL and data lines DL are disposed in the display panel 510, and a pixel P is disposed in each crossing region of the gate lines GL and the data lines DL. An image is displayed by driving the pixel P.

The controller 540 controls the gate driver 520 and the data driver 530.

The controller 540 outputs a gate control signal GCS for controlling the gate driver 520 and a data control signal DCS for controlling the data driver 530 by using a signal supplied from an external system. In addition, the controller 540 samples input image data input from the external system, rearranges the sampled input image data, and supplies the rearranged digital image data RGB to the data driver 530.

The gate control signal GCS includes a gate start pulse GSP, a gate shift clock GSC, a gate output enable signal GOE, a start signal Vst, and a gate clock GCLK. In addition, control signals for controlling a shift register 550 may be included in the gate control signal GCS.

The data control signal DCS includes a source start pulse SSP, a source shift clock signal SSC, a source output enable signal SOE, and a polarity control signal POL.

The data driver 530 supplies a data voltage to the data lines DL of the display panel 510. Specifically, the data driver 530 converts the image data RGB provided from the controller 540 into an analog data voltage and supplies the analog data voltage to the data lines DL.

The gate driver 520 may include the shift register 550.

The shift register 550 sequentially supplies a gate pulse to the gate lines GL during one frame by using the start signal and the gate clock transmitted from the controller 540. Herein, one frame refers to a period in which one image is output through the display panel 510. The gate pulse has a turn-on voltage capable of turning on a switching element (thin film transistor) disposed in the pixel P.

In addition, the shift register 550 supplies a gate-off signal capable of turning off the switching element to the gate line GL during the remaining period in which the gate pulse is not supplied in one frame. Hereinafter, the gate pulse and the gate-off signal are collectively referred to as a scan signal SS or Scan.

According to one embodiment of the present disclosure, the gate driver 520 may be provided on the substrate 110. As described above, a structure in which the gate driver 520 is directly provided on the substrate 110 is referred to as a gate-in-panel GIP structure. The gate driver 520 may include at least one of the thin film transistors 100, 200, 300, and 400 described above.

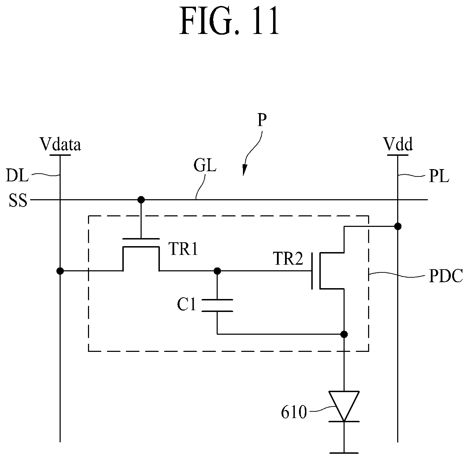

FIG. 11 is a circuit diagram of any one pixel P of FIG. 10.

The circuit diagram of FIG. 11 is an equivalent circuit diagram of the pixel P of the display apparatus 500 including an organic light emitting diode OLED as a display device 610.

The pixel P includes the display device 610 and a pixel driver PDC for driving the display device 610.

The display apparatus 500 according to another embodiment of the present disclosure may include at least one of the thin film transistors 100, 200, 300, and 400 described above. Any one of the thin film transistors 100, 200, 300, and 400 described above may be used as a first thin film transistor TR1 or a second thin film transistor TR2 of FIG. 11.

The first thin film transistor TR1 is connected to the gate line GL and the data line DL, and is turned on or off by the scan signal SS supplied through the gate line GL.

The data line DL provides the data voltage Vdata to the pixel driver PDC, and the first thin film transistor TR1 controls the application of the data voltage Vdata.

A driving power line PL provides a driving voltage Vdd to the display device 610, and the second thin film transistor TR2 controls the driving voltage Vdd. The driving voltage Vdd is a pixel driving voltage for driving the organic light emitting diode OLED corresponding to the display device 610.

When the first thin film transistor TR1 is turned on by the scan signal SS applied from the gate driver 520 through the gate line GL, the data voltage Vdata supplied through the data line DL is supplied to a gate electrode G2 of the second thin film transistor TR2 connected to the display device 610. The data voltage Vdata is charged in a first capacitor C1 formed between a source electrode S2 and the gate electrode G2 of the second thin film transistor TR2. The first capacitor C1 is a storage capacitor Cst.

The amount of current supplied to the organic light emitting diode OLED corresponding to the display device 610 through the second thin film transistor TR2 is controlled according to the data voltage Vdata, whereby it is possible to control the grayscale of light output from the display device 610.

As the display apparatus 500 according to another embodiment of the present disclosure includes at least one of the thin film transistors 100, 200, 300, and 400, the display apparatus 500 may have excellent display quality or long lifespan property, and driving stability may be improved.

As the thin film transistor according to one embodiment of the present disclosure includes the second gate electrode which contacts the first side of the first gate electrode and has the work function higher than that of the first gate electrode, it is possible to control the horizontal electric field intensity in the drain edge region.

As the horizontal electric field intensity of the drain edge region is controlled in the thin film transistor according to one embodiment of the present disclosure, the occurrence of deterioration in the drain edge region by the drain voltage may be reduced or suppressed.

As the thin film transistor according to another embodiment of the present disclosure further includes the third gate electrode which contacts the second side of the first gate electrode and has the work function lower than that of the first gate electrode, it may have an effect of increasing an effective channel length.

As the effect of increasing the threshold voltage is generated in the thin film transistor according to another embodiment of the present disclosure, driving stability may be improved.

As the display apparatus according to another embodiment of the present disclosure may include the above-described thin film transistor. Thus, the display apparatus according to another embodiment of the present disclosure may have excellent display quality or long lifespan property.

It will be apparent to those skilled in the art that various substitutions, modifications, and variations are possible within the scope of the present disclosure without departing from the technical idea and scope of the present disclosure. Therefore, the scope of the present disclosure is represented by the following claims, and all changes or modifications derived from the meaning, range and equivalent concept of the claims should be interpreted as being included in the scope of the present disclosure.

Further, the present disclosure includes the following clauses:
Clause 1. A thin film transistor comprising:
   an active layer including a channel portion;
   a gate insulating layer on the active layer; and
   a gate electrode on the gate insulating layer,
   wherein the gate electrode includes:
      a first gate electrode; and
      a second gate electrode,
   wherein each of the first gate electrode and the second gate electrode is spaced apart from the active layer and is disposed to face the active layer,
   the first gate electrode is in contact with the second gate electrode, and
   the first gate electrode has a work function different from a work function of the second gate electrode.
Clause 2. The thin film transistor of clause 1,
   wherein the first gate electrode has a first side and a second side opposite the first side,
   the second gate electrode is in contact with the first side of the first gate electrode, and
   the second gate electrode has a work function higher than that of the first gate electrode.
Clause 3. The thin film transistor of clause 2,
   wherein the difference between the work function of the second gate electrode and the work function of the first gate electrode is 0.1eV or greater than 0.1eV.
Clause 4. The thin film transistor of clause 2 or clause 3,
   wherein the first gate electrode includes any one of titanium, aluminum, nickel, chromium, and copper, and
   the second gate electrode includes any one of gold and platinum.
Clause 5. The thin film transistor of any of clauses 2-4,
   wherein the first gate electrode includes any one of titanium, aluminum, and nickel, and
   the second gate electrode includes any one of chromium, copper, gold, and platinum.
Clause 6. The thin film transistor of any preceding clause,
   wherein, in case of an off state, a charge density of a region overlapping the second gate electrode in the channel portion and a charge density of a region overlapping the first gate electrode in the channel portion are different from each other.
Clause 7. The thin film transistor of clause 6,
   wherein a charge density of a region overlapping the second gate electrode is higher than a charge density of a region overlapping the first gate electrode.
Clause 8. The thin film transistor of any preceding clause,
   wherein, in case of an on state, a horizontal electric field intensity of a region overlapping the second gate electrode and a horizontal electric field intensity of a region overlapping the first gate electrode in the channel portion are different from each other.
Clause 9. The thin film transistor of clause 8,
   wherein, in the channel portion, a horizontal electric field intensity of a region overlapping the second gate electrode is smaller than a horizontal electric field intensity of a region overlapping the first gate electrode.
Clause 10. The thin film transistor of any preceding clause,
   wherein the first gate electrode has a first side and a second side opposite the first side,
   the second gate electrode is in contact with the second side of the first gate electrode, and
   the second gate electrode has a work function lower than that of the first gate electrode.
Clause 11. The thin film transistor of clause 10,
   wherein the difference between the work function of the first gate electrode and the work function of the second gate electrode is 0.1eV or greater than 0.1eV.
Clause 12. The thin film transistor of clause 10 or 11,
   wherein the first gate electrode includes any one of gold and platinum, and
   the second gate electrode includes any one of titanium, aluminum, nickel, chromium, and copper.
Clause 13. The thin film transistor of any of clauses 10-12,
   wherein the first gate electrode includes any one of chromium, copper, gold, and platinum, and
   the second gate electrode includes any one of titanium, aluminum, and nickel.
Clause 14. The thin film transistor of clause 2,
   wherein the gate electrode further includes a third gate electrode,
   wherein the third gate electrode is spaced apart from the active layer and is disposed to face the active layer,
   the third gate electrode is in contact with the second side of the first gate electrode, and
   the third gate electrode has a work function lower than that of the second gate electrode.
Clause 15. The thin film transistor of clause 14,
   wherein the third gate electrode has a work function lower than that of the first gate electrode.
Clause 16. The thin film transistor of clause 14 or clause 15,
   wherein the difference between the work function of the second gate electrode and the work function of the first gate electrode is 0.1eV or greater than 0.1eV, and
   the difference between the work function of the first gate electrode and the work function of the third gate electrode is 0.1eV or greater than 0.1eV.
Clause 17. The thin film transistor of any of clauses 14-16,
   wherein the second gate electrode includes any one of gold and platinum, and
   each of the first gate electrode and the third gate electrode includes any one of titanium, aluminum, nickel, chromium, and copper.
Clause 18. The thin film transistor of any of clauses 14-17,
   wherein the second gate electrode includes any one of chromium and copper, and
   each of the first gate electrode and the third gate electrode includes any one of titanium, aluminum, and nickel.
Clause 19. The thin film transistor of any of clauses 14-18,
   wherein the first gate electrode includes any one of chromium and copper,
   the second gate electrode includes any one of gold and platinum, and
   the third gate electrode includes any one of titanium, aluminum, and nickel.
Clause 20. The thin film transistor of any of clauses 14-19,
   wherein, in case of an off state, a charge density of a region overlapping the first gate electrode in the channel portion, a charge density of a region overlapping the second gate electrode in the channel portion, and a charge density of a region overlapping the third gate electrode in the channel portion are different from each other.
Clause 21. The thin film transistor of clause 20,
   wherein, in the channel portion, a charge density of a region overlapping the second gate electrode is higher than a charge density of a region overlapping the first gate electrode, and
   a charge density of a region overlapping the first gate electrode is higher than a charge density of a region overlapping the third gate electrode.
Clause 22. The thin film transistor of any of clauses 14-21,
   wherein, in case of an on state, a horizontal electric field intensity of a region overlapping the second gate electrode in the channel portion and a horizontal electric field intensity of a region overlapping the third gate electrode in the channel portion are different from each other.
Clause 23. The thin film transistor of clause 22,
   wherein, in the channel portion, a horizontal electric field intensity of a region overlapping the second gate electrode is smaller than a horizontal electric field intensity of a region overlapping the third gate electrode.
Clause 24. A display apparatus including a thin film transistor according to any one of clauses 1 to 23.

## Claims

1. A thin film transistor comprising:
an active layer, the active layer including a channel portion;
a gate insulating layer disposed on the active layer; and
a gate electrode disposed on the gate insulating layer,
wherein the gate electrode includes:
a first gate electrode; and
a second gate electrode,
wherein each of the first gate electrode and the second gate electrode is spaced apart from the active layer and is disposed to face the active layer,
wherein the first gate electrode contacts the second gate electrode, and
wherein a work function of the first gate electrode is different from a work function of the second gate electrode.

2. The thin film transistor of claim 1,
wherein the first gate electrode has a first side and a second side opposite the first side,
wherein the second gate electrode contacts the first side of the first gate electrode, and
wherein the work function of the second gate electrode is higher than the work function of the first gate electrode, optionally
wherein a difference between the work function of the second gate electrode and the work function of the first gate electrode is at least 0.1eV.

3. The thin film transistor of claim 2,
wherein the first gate electrode comprises at least one of titanium, aluminum, nickel, chromium, and/or copper, and
the second gate electrode comprises at least one of chromium, copper, gold, and/or platinum.

4. The thin film transistor of any preceding claim,
wherein, when the thin film transistor is in an off state, a charge density of a region overlapping the second gate electrode in the channel portion differs from a charge density of a region overlapping the first gate electrode in the channel portion, optionally wherein a charge density of the region overlapping the second gate electrode is higher than a charge density of the region overlapping the first gate electrode.

5. The thin film transistor of any preceding claim,
wherein, when the thin film transistor is in an on state, a horizontal electric field intensity of a region overlapping the second gate electrode differs from a horizontal electric field intensity of a region overlapping the first gate electrode in the channel portion, optionally wherein, in the channel portion, a horizontal electric field intensity of a region overlapping the second gate electrode is smaller than a horizontal electric field intensity of a region overlapping the first gate electrode.

6. The thin film transistor of claim 1,
wherein the first gate electrode has a first side and a second side opposite the first side,
wherein the second gate electrode contacts the second side of the first gate electrode, and
wherein the work function of the second gate electrode is lower than the work function of the first gate electrode, optionally
wherein a difference between the work function of the first gate electrode and the work function of the second gate electrode is at least 0.1eV.

7. The thin film transistor of claim 6,
wherein the first gate electrode comprises at least one of chromium, copper, gold and/or platinum, and
the second gate electrode comprises at least one of titanium, aluminum, nickel, chromium, and/or copper.

8. The thin film transistor of any of claims 2-7,
wherein the gate electrode further includes a third gate electrode,
wherein the third gate electrode is spaced apart from the active layer and is disposed to face the active layer,
wherein the third gate electrode contacts the second side of the first gate electrode, and
wherein the work function of the third gate electrode is lower than the work function of the second gate electrode, optionally
wherein the third gate electrode has a work function lower than that of the first gate electrode.

9. The thin film transistor of claim 8,
wherein
a difference between the work function of the first gate electrode and the work function of the third gate electrode is at least 0.1eV.

10. The thin film transistor of claim 8 or 9,
wherein the first gate electrode includes any one of chromium and copper,
wherein the second gate electrode includes any one of gold and platinum, and
wherein the third gate electrode includes any one of titanium, aluminum, and nickel.

11. The thin film transistor of any of claims 9-10,
wherein, when the thin film transistor is in an off state, a charge density of a region overlapping the first gate electrode in the channel portion, a charge density of a region overlapping the second gate electrode in the channel portion, and a charge density of a region overlapping the third gate electrode in the channel portion differ from each other.

12. The thin film transistor of claim 11,
wherein, in the channel portion, a charge density of a region overlapping the second gate electrode is higher than a charge density of a region overlapping the first gate electrode, and
wherein a charge density of a region overlapping the first gate electrode is higher than a charge density of a region overlapping the third gate electrode.

13. The thin film transistor of any of claims 8-12,
wherein, when the thin film transistor is in an on state, a horizontal electric field intensity of a region overlapping the second gate electrode in the channel portion differs from a horizontal electric field intensity of a region overlapping the third gate electrode in the channel portion.

14. The thin film transistor of claim 13,
wherein, in the channel portion, a horizontal electric field intensity of a region overlapping the second gate electrode is smaller than a horizontal electric field intensity of a region overlapping the third gate electrode.

15. A display apparatus including a thin film transistor according to any one of claims 1 to 14.
